# EUROPÄISCHE PATENTANMELDUNG

(11) **EP 0 590 413 A1**
(43) Veröffentlichungstag der Anmeldung: **06.04.1994**
(21) Anmeldenummer: 93114839.9
(22) Anmeldetag: 15.09.1993
(51) Int. Cl.: G01C 17/28, H05K 5/00

(54) **Elektronischer Kompass für die Navigation von Fahrzeugen**

(30) Priorität: 28.09.1992 DE 4232474
(71) Anmelder: SIEMENS AKTIENGESELLSCHAFT, D-80333 München (DE)
(72) Erfinder: Lahner, Karlheinz, D-93049 Regensburg (DE); Kinzler, Hans, D-93049 Regensburg (DE)

(57) **Zusammenfassung**

Elektronischer Kompaß für die Navigation von Fahrzeugen mit einem zweiteiligen Gehäuse (K1, K2), das Schaltungsträger (P1, P2) enthält, von denen der eine (P1) einen Erdmagnetfeldsensor (S1) sowie erste Leitungsabschnitte (Q1) und eine erste Leitungshalterung (B1) und der andere (P2) eine Auswerteelektronik (S2) zur Auswertung der Ausgangssignale des Erdmagnetfeldsensors (S1) sowie zweite Leitungabschnitte (Q2) und eine zweite Leitungshalterung (B2) trägt. Die Leitungshalterungen (B1, B2) sind jeweils über eine oder mehrere lose verlegte Anschlußleitungen (L) verbunden. Die zwei Gehäuseabschnitte (K1, K2) hängen über ein Gelenk (G) gegeneinander schwenkbar aneinander. Die Anschlußleitungen (L) sind derart zwischen den zwei Leitungshalterungen (B1, B2) verlegt, daß die beim Schwenken in den Anschlußleitungen (L) auftretenden Kräfte auch bei den maximal zugelassenen Schwenkungen (R) der Gehäuseabschnitte (K1, K2) nicht die elektrische Verbindung zwischen dem Erdmagnetfeldsensor (S1) und der Auswerteelektronik (S2) gefährden.

## Beschreibung

Die Erfindung geht von dem im Oberbegriff des Patentanspruches 1 definierten Gegenstand aus, der für sich in identischer Weise oder ähnlicher Weise vielfach vorbekannt ist, vgl. z.B. die den konstruktiven Aufbau von Erdmagnetfeldsensoren für elektronische Kompasse betreffenden
- EP-B1-0 065 579 (= 79 P 2415 E),
- EP-B1-0 065 762 (= 81 P 6886 E),
- EP-B1-0 067 337 (= 81 P 6896 E),
- EP-B2-0 067 338 (= 81 P 6897 E) und
- EP-B1-0 135 933 (= 83 P 1784 E).

Eines der Hauptprobleme solcher Erdmagnetfeldsensoren ist einerseits ihre Befestigung an einer beliebigen Befestigungsstelle im Fahrzeug, wobei diese Befestigungsstelle - z.B. mehr oder weniger rechts oben an der Frontscheibe - oft einen nur ungenau definierten Winkel zur Horizontalen und zur Fahrzeuglängsachse aufweisen kann, so daß oft sogar erhebliche Winkelunterschiede selbst von Fahrzeug zu Fahrzeug innerhalb desselben Fahrzeugtypes bestehen. Der Kompaß sollte aber, auch wenn er an einer beliebigen Fahrzeugstelle angebracht wurde, durch eine mechanische Maßnahme ausreichend genau in - zumindest weitgehend - horizontaler Richtung justiert werden können.

Ferner sollte der Kompaß möglichst unempfindlich sein gegen magnetisch, kapazitiv und / oder elektromagnetisch eingekoppelte Störsignale, also z.B. gegen Störungen durch die Motorsteuerung, durch das Einschalten der elektrischen Heizung, der Klimaanlage, des Scheibenwischermotors, der Innenraumbeleuchtung, usw.

Die Erfindung geht von der Erkenntnis aus, daß - unabhängig von eventuellen zusätzlichen Abschirmmaßnahmen - nicht nur der Abstand zwischen dem Erdmagnetfeldsensor bis zur Auswerteelektronik, die zur Auswertung der Ausgangssignale des Erdmagnetfeldsensors dient, möglichst klein sein soll, so daß in die elektrischen Leitungen zwischen diesen beiden Schaltungsabschnitten sehr kurz und damit weitgehend störungsfrei sind.

Zusätzlich sollte die ganze Elektronik in zwei engstens benachbarte Schaltungsabschnitte aufgeteilt werden, wovon der eine gegen den anderen schwenkbar sein soll, damit sowohl der den Erdmagnetfeldsensor enthaltende Schaltungsabschnitt unabhängig vom Neigungswinkel der Befestigungsstelle ausreichend horizontal justiert werden kann, als auch damit - trotz der Möglichkeit, den Kompaß an einer beliebigen Befestigungsstelle in jedem beliebigen Fahrzeug zu befestigen - für Werkstätten und Kompaßhersteller keine Vorratshaltung für viele unterschiedliche Konstruktionen von solchen Kompassen nötig ist.

Die Aufgabe,
- einen weitgehend störungsunempfindlichen, räumlich kleinen, unabhängig vom Fahrzeugtyp - trotz beliebiger Befestigungsstelle - ausreichend horizontal justierbaren elektronischen Kompaß zu bieten, wobei trotzdem der Aufwand für die Herstellung des Kompasses gering sein soll,
wird erfindungsgemäß durch den im Patentanspruch 1 definierten Gegenstand gelöst.

Die in den Unteransprüchen definierten Gegenstände gestatten, zusätzliche Vorteile zu erreichen. U.a. gestatten nämlich die zusätzlichen Maßnahmen gemäß dem Patentanspruch
2, in für Massenfertigung geeigneter Weise auf engstem Raume gleichzeitig viele Leitungen anbringen zu können,
3, die Elektronik des Kompasses in besonders kompakter Weise unterbringen zu können,
4, ein besonders störunempfindliches, nämlich optisches Ausgangssignal nach außerhalb des Kompasses - z.B. zum weit entfernt angebrachten Bordcomputer - abzuliefern,
5, auch die Gefahr von Störungen, die mit der Zeit - oder schlagartig auf ein Mal - durch Staub, Dreck o. dgl. verursacht werden können, zu reduzieren, und
6, dem Kompaß nach der Justierung des Erdmagnetfeldsensors in seine - zumindest weitgehend - horizontale Lage eine dauerhaft steife Form zu geben.

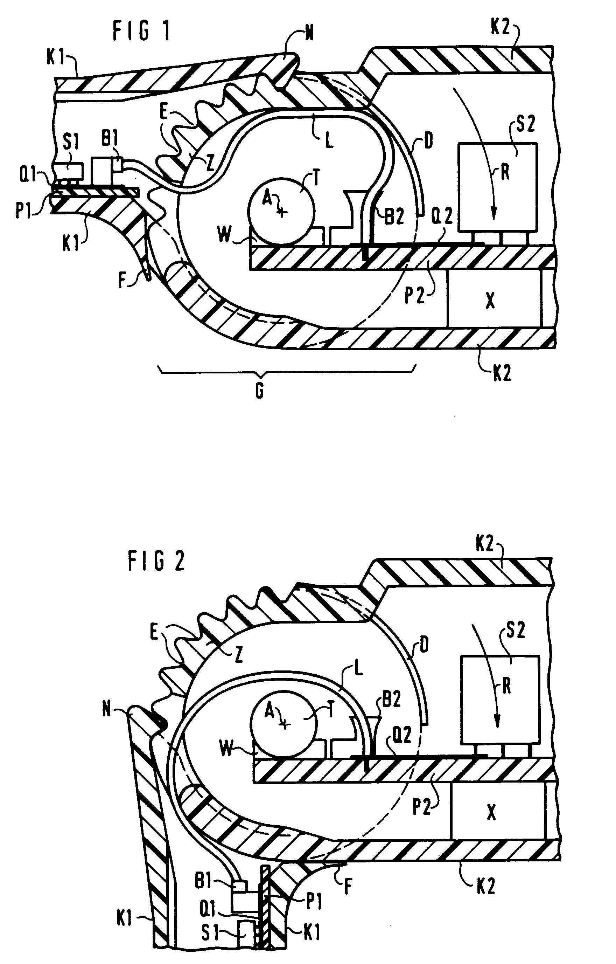

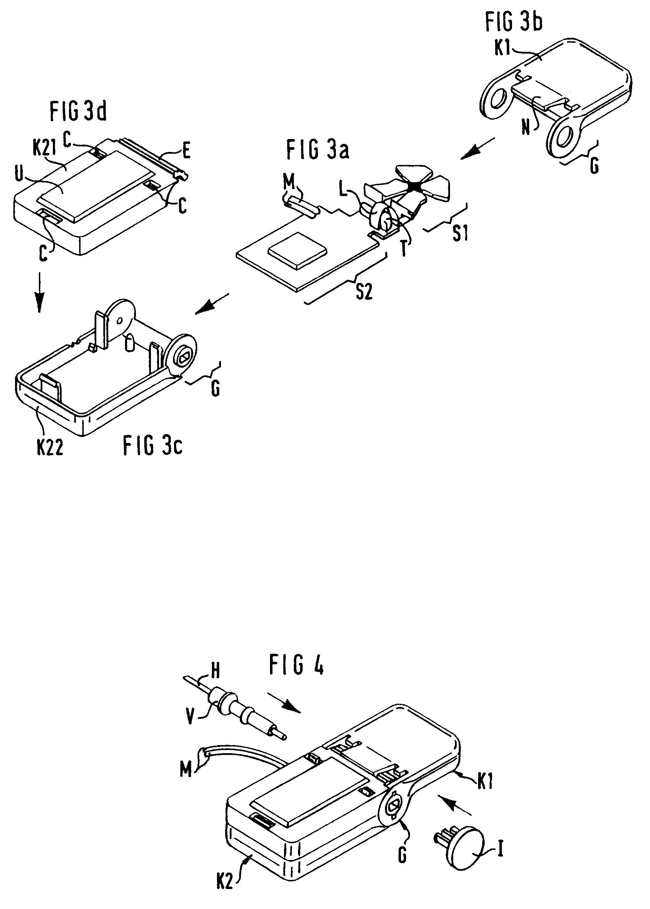

Die Erfindung und Weiterbildungen derselben werden anhand der in den vier Figuren gezeigten Schemen eines Ausführungsbeispieles der Erfindung weiter erläutert, welche der Übersichtlichkeit wegen jeweils möglichst einfach dargestellt wurden. Dabei zeigt die Figur
1 in stark vergrößertem Maßstab einen Querschnitt durch das Ausführungsbeispiel, während das Gelenk gestreckt ist,
2 im selben, stark vergrößertem Maßstab den in der Figur 1 gezeigten Querschnitt durch das Ausführungsbeispiel, während das Gelenk um 90° abgewinkelt ist,
3 zwar in einer Art Explosionsdarstellung, aber angenähert im originalen Maßstab, eine schräge Ansicht der einzelnen Teile des Gehäuses zusammen mit den beiden, hier bereits miteinander verbundenen Schaltungsabschnitten, und
4 eine der Figur 3 entsprechende schräge Außenansicht des fertig montierten Kompasses, während das Gelenk - vgl. die Figur 1 - gestreckt ist.

Alle Figuren zeigen also ein spezielles Beispiel des erfindungsgemäßen elektronischen Kompasses, der für die Navigation von Fahrzeugen dient. Die Figuren unterscheiden sich im wesentlichen nur durch die verschiedenen Ansichten und Maßstäbe. Weil im gezeigten Beispiel alle in den verschiedenen Patentansprüchen angegebenen Maßnahmen gemeinsam verwirklicht sind, weist dieses Beispiel auch die Summe der verschiedenen genannten Vorteile auf.

Der Kompaß besitzt das in allen Figuren gezeigte, z.B. aus gespritztem Kunststoff bestehende Gehäuse K1-G-K2, das erfindungsgemäß jeweils zwei Gehäuseabschnitte aufweist, nämlich den ersten Gehäuseabschnitt K1 und den anderen Gehäuseabschnitt K2 - bzw. gemäß der Explosionsdarstellung der Figur 3 die dort noch voneinander getrennten Teile K21 und K22 des Gehäuseabschnittes K2. Alle Figuren zeigen, daß die Gehäuseabschnitte K1 und K2 über das Gelenk G schwenkbar aneinanderhängen - in der Explosionsdarstellung der Figur 3 sind die Gelenkteile G nämlich noch nicht entsprechend der Figur 4 ineinandergeschoben. Die Figuren 1 und 2 unterscheiden sich im wesentlichen nur durch die unterschiedlich starke Schwenkung der Gehäuseabschnitte K1 und K2 in der Schwenkrichtung R um das Gelenk G.

In jedem der beiden Gehäuseabschnitten K1 und K2 ist jeweils eine Leiterplatte, vgl. P1 und P2, als Schaltungsträger befestigt. Der im Inneren des ersten Gehäuseabschnittes K1 angebrachte erste Schaltungsträger P1, vgl. besonders die Figuren 1 und 2, trägt den Erdmagnetfeldsensor S1 sowie erste Leitungsabschnitte Q1 und eine erste Leitungshalterung B1, vgl. die Figuren 1, 2 und 3a. Die Leitungsabschnitte Q1 verbinden Anschlüsse des Erdmagnetfeldsensors S1 über die Leitungshalterung B1 mit den Leitungen L, die hier durch ein Flachbandkabel gebildet sind, das viele nebeneinander zu einem flachen Band angeordnete Einzelleitungen L enthält, vgl. die Figuren 1, 2 und 3a. An der Leitungshalterung B1 ist also jeweils das erste Ende der im übrigen als Flachbandkabel lose verlegten Leitungen L - oder jeweils das eine Ende mehrerer, lose verlegter Leitungen L - angeschlossen, z.B. angelötet.

Der im Inneren des zweiten Gehäuseabschnittes K2 - bzw. K21/K22 - angebrachte zweite Schaltungsträger P2 trägt die Auswerteelektronik S2, welcher die Ausgangssignale des Erdmagnetfeldsensors S1 auswertet, also seinerseits eigene Ausgangssignale liefert, welche Aussagen über die Richtung der Fahrzeuglängsachse zum Erdmagnetfeld und zur den übrigen Himmelsrichtungen darstellen. Dieser zweite Schaltungsträger P2 trägt ferner zweite Leitungabschnitte Q2 und eine zweite Leitungshalterung B2, vgl. wieder die Figuren 1, 2 und 3a. Die Leitungsabschnitte Q2 verbinden Anschlüsse des Schaltungsabschnittes S2 über die Leitungshalterung B2 mit den Leitungen L, vgl. die Figuren 1, 2 und 3a. An der Leitungshalterung B2 ist also das andere Ende der lose verlegten Leitungen L des Flachbandkabels angeschlossen.

Die Stromversorgung des Schaltungsabschnittes S2 ist über die Anschlüsse M erreicht, vgl. die Figuren 3a und 4. Die Stromversorgung des Erdmagnetfeldsensors S1 ist im gezeigten Beispiel über den Schaltungsabschnitt S2 und über zwei der hier vielen Leitungen L des Flachbandkabels erreicht, vgl. besonders die Figuren 1, 2 und 3a.

Dadurch, daß das Gehäuse K1, K2 zwei über ein Gelenk G aneinander hängende, gegeneinander schwenkbare Gehäuseabschnitte K1, K2 aufweist, kann der eine Gehäuseabschnitt K1 gegenüber dem anderen Gehäuseabschnitt K1 zumindest ein einziges Mal zum Zwecke der Justierung des Erdmagnetfeldsensors S1 geschwenkt werden. Sobald die Justierung der Erdmagnetfeldsensor S1 im betreffenden ausreichend in Ordnung ist, kann nämlich das Gelenk - im Prinzip auf beliebige Art - arretiert werden, z.B. verklebt, verschraubt und / oder verschweißt werden, um dem Kompaß nach der Justierung des Erdmagnetfeldsensors in seine - zumindest weitgehend - horizontale Lage eine dauerhaft steife Form zu geben. Das Arretieren kann z.B. auch durch eine in der Figur 4 gezeigte Verschlußkappe I erreicht werden, welche das Gelenk G verklemmt und welche überdies im Bereich des Gelenkes G eine gewisse Staub- und Wasserdichtigkeit des Gehäuses K1-G-K2 zu erreichen gestattet.

Bei der Erfindung sind die Leitungen L derart zwischen den zwei Leitungshalterungen B1, B2 lose verlegt sind, daß die beim Schwenken in den Leitungen L auftretenden Kräfte - vor allem die Zugspannungen in den Leitungen L und die Biegekräfte an den in den Leitungshalterungen B1, B2 angeschlossenen Enden der Leitungen L - auch bei den maximal zugelassenen Schwenkungen R der Gehäuseabschnitte K1, K2 nicht die elektrische Verbindung zwischen dem Erdmagnetfeldsensor S1 und der Auswerteelektronik S2 gefährden. Besonders die Figuren 1 und 2 veranschaulichen, daß die Leitungen L bei jedem Schwenkungswinkel ausreichend locker verlegt bleiben, daß z.B. die Lötstellen in den beiden Leitungshalterungen B1, B2 trotz der dortigen Biegekräfte nicht gefährdet sind; - das wird im gezeigten Beispiel auch dadurch gefördert, daß die Leitungshalterung B2 oben trichterartig etwas erweitert ist.

Die Montage des gezeigten Beispieles ist im Prinzip zwar auf verschiedene Weise möglich. Die einzelnen Montageschritte eine besonders günstigen Montageweise sind am leichtesten aus der Figur 3 zu erkennen. Nach dem Fertigmontieren der in der Figur 3a gezeigten gesamten Schaltung kann man kann man den ersten Gehäuseabschnitt K1 über den ersten Schaltungsabschnitt S1, also über die erste Leiterplatte P1 zusammen mit dem Erdmagnetfeldsensor S1 stecken, wobei die Lage dieser Leiterplatte P1 z.B. durch den in den Figuren 1 und 2 gezeigten, im Inneren des Gehäuseabschnittes K1 angebrachten Sockel X zusätzlich stabilisiert sein kann.

Danach legt man den anderen Schaltungsabschnitt S2, also z.B. gemäß den Figuren 1 und 2, auf den unteren Teil K22 des anderen Gehäuseabschnitt K22/K21, wobei man die entsprechenden, in den Figuren 3b und 3c erkennbaren Gelenkteile G ineinanderschieben kann, bis das Gelenkteil G des Gehäuseabschnittes K1 an dem - nur in den stark vergrößerten Figuren 1 und 2, aber nicht mehr in den Figuren 3 gezeigten - Anschlag D anstößt und bis die in der Figur 3c angedeuteten, in der Gelenkachse angebrachten Außenzapfen in die in der Figur 3b gezeigten entsprechenden, in der Gelenkachse angebrachten Löcher im Gelenkteil G einrasten, wodurch schließlich das schwenkbare Gelenk gebildet wird. Schließlich deckt man gemäß der Figur 4 das untere Teil K22 des Gehäuseabschnittes K2 mittels des in der Figur 3d gezeigten oberen Teils K21 so ab, daß sowohl die in den Figuren 1, 2, 3d und 4 gezeigte Zahnung E des zahnkranzähnlichen Teils Z durch die in den Figuren 1, 2, 3b und 4 gezeigte Rasterzunge N erfaßt wird, als auch daß die drei in der Figur 3c gezeigten elastischen Sperrzungen in den drei zugehörenden, in der Figur 3d gezeigten Öffnungen C einrasten.

Zum Öffnen des Kompasses kann man umgekehrt vorgehen: man lockert die Sperrzungen in den Öffnungen C, hebt das obere Teil K21 des Gehäuseabschnittes ab, entfernt den unteren Gehäuseabschnitt K22 und kann dann den Schaltungsabschnitt S1 von seinem Gehäuseabschnitt K1 trennen.

Der Gehäuseabschnitt K2, vgl. die Figur 3d, weist eine Klebefläche U auf, die z.B. aus einem klebenden Kunststoffstreifen besteht. Diese Klebefläche ist jene Stelle, mit der das gezeigte Beispiel des erfindungsgemäßen Kompasses an einer beliebigen Stelle am Fahrzeug / im Fahrzeug befestigt werden kann. Mit dieser Klebefläche kann man das Gehäuse K1-G-K2 also z.B. rechts oben an der Frontscheibe oder am Dach im Inneren des Fahrzeuges befestigen. Danach kann man mittels des Gelenkes G den Gehäuseabschnitt K1, der den Erdmagnetfeldsensor S1 enthält, ausreichend horizontal justieren. Schon durch die Zahnung E im Zahnkranz Z, vgl. die Figuren 1, 2, 3d und 4, in Verbindung mit der elastischen Rasterzunge N, vgl. die Figuren 1, 2, 3b und 4, erreicht man eine gewisse Arretierung des Gehäuseabschnittes K1, die zumindest vorläufig reicht, wobei danach die Arretierung wie beschrieben weiter verstärkt werden kann, also z.B. mittels der in der Figur 4 gezeigten Verschlußkappe I.

Damit kann der erfindungsgemäße Erdmagnetfeldsensor S1 wegen seines zweiteiligen, schwenkbaren Gehäuses K1-G-K2 an einer beliebigen Stelle im Fahrzeug und damit in beliebiger Schräglage befestigt werden - meistens wird die parallel zur Straßenfläche liegende sog. horizontale Lage angestrebt sein. Wie also schief zur Straßenfläche auch immer die Befestigungsstelle U des Kompasses im Fahrzeug ist, - der Erdmagnetfeldsensor S1 kann wegen des Gelenkes G in jede angestrebte Lage hineingeschwenkt werden. Weil der diesen Erdmagnetfeldsensor S1 enthaltende Gehäuseabschnitt K1 erfindungsgemäß ein besonders geringes Gesamtgewicht hat, weil die Auswerteelektronik S2 im anderen Gehäuseabschnitt K2 untergebracht ist, werden die üblichen Erschütterungen im Fahrzeug auch auf die Dauern nur schwache Biegemomente auf das Gelenk G ausüben, so daß die Zuverlässigkeit Justierung des Erdmagnetfeldsensor S1 auch auf Dauer wenig gefährdet ist.

Überdies ist die räumliche Entfernung zwischen dem Erdmagnetfeldsensor S1 und seiner Auswerteschaltung S2 sehr klein. Wegen dieser Kompaktheit kann der Pegel des sehr schwachen Ausgangssignales des Erdmagnetfeldsensors S1 durch die Auswerteschaltung S2 im Kompaß stark angehoben werden, und in ihr überdies hinsichtlich der Fahrrichtung des Fahrzeuges analysiert werden. Der Kompaß ist wegen dieser Kompaktheit, vor allem wegen der Kürze der Leitungen L, besonders unempfindlich gegen magnetisch, kapazitiv und / oder elektromagnetisch eingekoppelte Störsignale.

Trotzdem ist der Aufwand für die Herstellung des erfindungsgemäßen Kompasses, wie das gezeigte Beispiel zeigt, relativ gering, gemessen an den durch die Erfindung erreichten Vorteilen.

Selbst wenn man Einzelheiten des gezeigten Beispieles abändert, nämlich - innerhalb eines vernünftigen Rahmens - durch analog wirkende andere Teile ersetzt, bleiben die dargelegten Vorteile der Erfindung zumindest weitgehend erhalten.

Um in für Massenfertigung geeigneter Weise auf engstem Raume gleichzeitig besonders viele Leitungen auf besonders leichte, auch für Massenfertigung geeignete Weise anbringen zu können, kann man also die Leitungen L1, L2 jeweils durch ein Flachbandkabel mit jeweils mehreren Einzelleitungen bilden.

Um die Elektronik des Kompasses in besonders kompakter Weise im Gehäuse K1-G-K2 unterzubringen, kann man in einem - im Bereich der Achse A des Gelenkes G liegenden - Freiraum zwischen den Gehäuseabschnitten K1, K2 einen weiteren Schaltungsabschnitt T anbringen, der seinerseits über mindestens eine eigene Leitung z.B. mit einem Ausgang der Auswerteelektronik S2 verbunden ist, vgl. Q2.

Damit der Kompaß nach außen - z.B. zu einem Bordcomputer hin, der am Instrumentenpaneel des Fahrers angebracht ist - ein besonders störunempfindliches, nämlich optisches statt elektrisches Ausgangssignal abliefert, kann, zur Umsetzung von Ausgangssignalen des anderen Schaltungsabschnittes S2 in optische Ausgangssignale, die Auswerteelektronik S2 oder der weitere Schaltungsabschnitt T ein elektrooptisches Bauelement T - z.B eine entsprechende Leuchtdiode T - als Anschlußstelle eines in der Figur 4 gezeigten Steckers V eines Glasfaserkabels H darstellen. Dieses Bauelement kann, selbst wenn es einen weiteren Schaltungsabschnitt T bildet, - z.B. über einen eigenen Sockel W - sogar ebenfalls an einer der beider Leiterplatten P1, P2 befestigt sein, wie beim gezeigten Beispiel an der Leiterplatte P2.

Um auch die Gefahr von jenen Störungen zu reduzieren, die mit der Zeit - oder schlagartig auf einmal - durch Staub, Dreck o. dgl. verursacht werden können, können beide Gehäuseabschnitte K1, K2 zusammen mit dem Gelenk G eine den Erdmagnetfeldsensor S1 und die Auswerteelektronik S2 weitgehend vor Staub schützende Hülle bilden. Dazu kann auch die Rasterzunge N besonders breit gemacht werden, vgl. die Figuren 3b und 4. Außerdem kann man durch geschickte Formgebung und durch die Wahl elastischer Materialien selbst im der Rasterzunge N gegenüberliegenden Bereich F, vgl. die Figuren 1 und 2, eine hohe Dichtigkeit des Gehäuses erreichen.

## Patentansprüche

1. Elektronischer Kompaß für die Navigation von Fahrzeugen, mit einem Gehäuse (K1, K2), das einen Schaltungsträger (P1, P2) enthält, der einen auszuwertende Ausgangssignale liefernden Erdmagnetfeldsensor (S1) trägt,
- wobei der Schaltungsträger (P1, P2) auch Leitungsabschnitte (Q1, Q2) und mindestens eine Leitungshalterung (B1, B2) trägt,
- wobei an der Leitungshalterung (B1, B2) das eine Ende einer lose verlegten Anschlußleitung (L) - oder jeweils das eine Ende mehrerer, lose verlegter Anschlußleitungen (L) - angeschlossen ist, und
- wobei der Schaltungsträger (P1, P2) in dem Gehäuse (K1, K2) angebracht ist,
**dadurch gekennzeichnet**
- daß zwei solche Schaltungsträger (P1, P2) im Gehäuse (K1, K2) angebracht sind,
+ von denen der erste Schaltungsträger (P1) den Erdmagnetfeldsensor (S1) sowie erste Leitungsabschnitte (Q1) und eine erste Leitungshalterung (B1) und
+ der zweite Schaltungsträger (P2) eine Auswerteelektronik (S2) zur Auswertung der Ausgangssignale des Erdmagnetfeldsensors (S1) sowie zweite Leitungabschnitte (Q2) und eine zweite Leitungshalterung (B2) trägt,
- daß das Gehäuse (K1, K2) zwei über ein Gelenk (G) aneinander hängende und damit - zumindest ein einziges Mal zum Zwecke der Justierung des Erdmagnetfeldsensors (S1) - gegeneinander schwenkbare Gehäuseabschnitte (K1, K2) aufweist, in denen jeweils einer der beiden Schaltungsträger (P1, P2) angebracht ist, und
- daß die betreffenden Anschlußleitungen (L) derart zwischen den zwei Leitungshalterungen (B1, B2) lose verlegt sind, daß die beim Schwenken in den Anschlußleitungen (L) auftretenden Kräfte - vor allem die Zugspannungen in den Anschlußleitungen (L) und die Biegekräfte an den in den Leitungshalterungen (B1, B2) angeschlossenen Enden der Anschlußleitungen (L) - auch bei den maximal zugelassenen Schwenkungen (R) der Gehäuseabschnitte (K1, K2) nicht die elektrische Verbindung zwischen dem Erdmagnetfeldsensor (S1) und der Auswerteelektronik (S2) gefährden.

2. Kompaß nach Patentanspruch 1,
**dadurch gekennzeichnet,**
- daß die Leitungen (L1, L2) jeweils durch ein Flachbandkabel mit jeweils mehreren Einzelleitungen gebildet sind.

3. Kompaß nach Patentanspruch 1 oder 2,
**dadurch gekennzeichnet,**
- daß in einem im Bereich der Achse (A) des Gelenkes (G) liegenden Freiraum zwischen den Gehäuseabschnitten (K1, K2) ein weiterer Schaltungsabschnitt (T) angebracht ist, das über mindestens eine eigene Leitung (Q2) mit einem Ausgang der Auswerteelektronik (S2) verbunden ist.

4. Kompaß nach Patentanspruch 3,
**dadurch gekennzeichnet,**
- daß, zur Umsetzung von Ausgangssignalen des anderen Schaltungsabschnittes (S2) in optische Ausgangssignale, der weitere Schaltungsabschnitt (T) ein elektrooptisches Bauelement als Anschlußstelle eines Glasfaserkabels enthält.

5. Kompaß nach einem der vorhergehenden Patentansprüche,
**dadurch gekennzeichnet,**
- daß beide Gehäuseabschnitte (K1, K2) zusammen mit dem Gelenk (G) eine den Erdmagnetfeldsensor (S1) und die Auswerteelektronik (S2) weitgehend vor Staub schützende Hülle bilden.

6. Kompaß nach einem der vorhergehenden Patentansprüche,
**dadurch gekennzeichnet,**
- daß das Gelenk (G) arretierbar (N, E, Z) ist.
